# EUROPEAN PATENT APPLICATION

(11) **EP 4 495 990 A1**
(43) Date of publication of application: **22.01.2025**
(21) Application number: 23186525.4
(22) Date of filing: 19.07.2023
(51) Int. Cl.: H01L 23/36, H01L 23/538, H01L 29/20

(54) **SEMICONDUCTOR SUBSTRATE, SEMICONDUCTOR COMPONENT AND METHODS**

(71) Applicant: Infineon Technologies Austria AG, 9500 Villach (AT)
(72) Inventor: NÖBAUER, Gerhard, 9500 Villach (AT); JONES, Edward, Andrew, 9500 Villach (AT); FERRARA, Alessandro, 9523 Villach (AT); BLANK, Oliver, 9500 Villach (AT); PRECHTL, Gerhard, 9232 Rosegg (AT); KAHRIMANOVIC, Elvir, 9523 Lanskron (AT)
(74) Representative: JENSEN & SON

(57) **Abstract**

In an embodiment, a semiconductor die comprises a base substrate comprising a first major surface and a second major surface opposing the first major surface, the base substrate comprising a material other than a Group III nitride, a Group III nitride layer arranged on the first major surface of the base substrate, the Group III nitride layer comprising a Group III nitride device, a first metallization structure arranged on the Group III nitride layer and a second metallization structure arranged on the second major surface of the base layer. The second metallization structure comprises an electrically insulating inorganic layer arranged directly on the second major surface.

## Description

### BACKGROUND

To date, transistor devices used in power electronic applications have typically been fabricated with silicon (Si) semiconductor materials. Common transistor devices for power applications include Si CoolMOS^{®}, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times.

A semiconductor device is commonly mounted in a package which may include a substrate or a leadframe and which includes outer contacts which are used to mount the device on a redistribution board such as a printed circuit board.

US 2016/0268190 A1 describes packaging assemblies for a large are, GaN die comprising one or more lateral GaN power transistor devices that comprise an interposer sub-assembly comprising the lateral GaN die and a leadframe. The sub-assembly may be mounted in a standard power module, or alternatively on a substrate, such as a printed circuit board. For high current applications, the sub-assembly also comprises a ceramic substrate for heat dissipation.

Further improvements in thermal management for Group III nitride devices are, however, desirable.

### SUMMARY

In an embodiment, a semiconductor die comprises a base substrate comprising a first major surface and a second major surface opposing the first major surface, the base substrate comprising a material other than a Group III nitride, a Group III nitride layer arranged on the first major surface of the base substrate, the Group III nitride layer comprising a Group III nitride device, a first metallization structure arranged on the Group III nitride layer and a second metallization structure arranged on the second major surface of the base layer. The second metallization structure comprises an electrically insulating inorganic layer arranged directly on the second major surface.

In an embodiment, a method comprises forming a first opening in a first metallization structure formed on a Group III nitride layer arranged on a first major surface of a base substrate, wherein the base substrate comprises a material other than a Group III nitride and comprises a second metallization structure arranged on a second major surface of the base layer that opposes the first major surface, the second metallization structure comprising an electrically insulating inorganic layer arranged directly on the second major surface, wherein the Group III nitride layer comprises a Group III nitride device and the first metallization structure comprises one or more electrically insulating layers and one or more electrically conductive layers that are coupled to the Group III nitride device, increasing the depth of the first opening through the Group III nitride layer and into the base substrate and forming an extended first opening, the extended first opening having a base located in the base substrate, forming a mask that covers the extended first opening and that exposes a conductive layer of the first metallization structure in a second opening, removing the mask and forming a conductive layer that lines the second opening, the extended first opening and the outer surface of the first metallization structure and structuring the conductive layer to form a first portion that is electrically coupled to the base substrate and a second portion that is electrically coupled to the conductive layer of the first metallization structure.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1A illustrates a cross-sectional view of a semiconductor wafer according to an embodiment and figure 1B illustrates a top view of a semiconductor die according to an embodiment.
Figure 2 illustrates a cross-sectional view of a semiconductor component according to an embodiment which comprises a semiconductor die.
Figure 3 illustrates a cross-sectional view of a semiconductor component according to an embodiment which comprises a semiconductor die.
Figure 4 illustrates a cross-sectional view of a semiconductor component according to an embodiment which comprises a semiconductor die.
Figure 5 illustrates a cross-sectional view of a semiconductor component according to an embodiment which comprises a semiconductor die.
Figure 6, which includes figure 6A to 6D, illustrates a method for fabricating a semiconductor wafer.
Figure 7, which includes figures 7A to 7G, illustrates a method for forming a vertical connection to a base substrate.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention.

The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐP_{b}N_{(1-a-b)}), for example. Aluminum gallium nitride and AlGaN refers to an alloy described by the formula AlₓGa₍₁₋ₓ₎N, where 0 < x < 1.

GaN-based transistor devices have the ability to provide a very low channel resistance per die area, and also switch on and off with very high current and voltage slew rate. A small semiconductor die or chip, e.g. a die having an area 10mm², may be utilized to achieve a desired low Rds.on value. Consequently, a small power dissipation could cause a temperature rise of the chip in the event of inadequate thermal dissipation to the heatsink and air. In order to alleviate the thermal stress of the chip, effective cooling is desirable.

GaN HEMT devices have a planar structure which means that all electrical connections are located on one side of the chip only. According to the present disclosure, it is proposed to electrically isolate the chip from the package of the chip level and in this way decouple electrical from thermal path of the chip in place of e.g., a conventional utilization of a thermal interface material (TIM) between the chip and the heatsink which would have a higher thermal resistance due to its thickness (few hundreds of microns, e.g. 300 µm), On top side of the die, electrical connection is made to gate, source and drain, and, on the other side of the die, an inorganic isolation layer applied. The die isolation layer may have a thickness of a few hundreds of nm (nanometres) depending on desired isolation voltage requirement. This way the thickness of the thermal interface layer, in this case the inorganic die isolation layer deposited on the die, can be much better controlled and is significantly thinner thereby ensuring a much better thermal cooling of the die.

The backside of a Group III nitride device, for example GaN-based HEMT device, can be electrically isolated by way of the isolation layer arranged on the rear side of the base substrate because the base substrate may be internally connected to source or drain potential by the chip layout. It is also possible to have a device, such as a GaN-based HEMT device, with a separate substrate connection. In this case, the substrate potential may be brought to the die surface and made available as an additional contact. Since the GaN HEMT is a lateral device with a relatively-thin epi (epitaxial Group III nitride) layer, bringing a potential from the backside of the base substrate to the surface of the epitaxial Group III nitride is possible with standard layout techniques.

The thermally conductive and electrically insulating inorganic layer that is provided on the backside of the Group III nitride device, e.g. a lateral GaN HEMT device and/or GaN IC, provides an interconnect between chip and heatsink. The electrically insulating inorganic layer can be designed to withstand the source-drain voltage over the whole lifetime, for example by selection of the material and thickness. In some embodiments, the electrically insulating layer is an oxide or a nitride and may be formed of SiO₂. In some embodiments, the electrically insulating layer has a thickness d in the range 1 * Vds (in V) < d (in nm) < 100 * Vds (in V). In some embodiments, the electrically insulating layer has a thickness d in the range 10 * Vds (in V) < d (in nm) < 100 * Vds (in V). In an embodiment, the electrically insulating layer on the rear side of the base substrate is formed of SiO₂ and has a thickness d in the range 1 * Vds (in V) < d (in nm) < 100 * Vds (in V).

The dielectrically insulating layer, e.g. an oxide, can be deposited at the wafer level. After the oxide is on the substrate back side, the wafer is singulated into single dies, each having an electrically insulating layer on the rear surface (back side). The devices may be soldered onto a circuit board and a heat sink attached directly on the SiO₂ back side insulating layer.

The devices may be used to provide different circuits. For example, two transistor devices may be used to provide a half bridge circuit. In a half bridge configuration, the substrate of the low side transistor is at source potential and the substrate of the high side transistor is at drain potential. The SiO₂ back side layer is designed to block source/drain potential since the heat sink is typically on ground or on unknown potential. Electric breakdown may occur directly at the sidewall of the electrically insulating SiO₂ back side layer. To mitigate this risk, a thicker oxide may be used or an additional back side structured metallization can be used. This increases the spacing between the substrate and the heat sink and therefore reduces the electrical field.

The Group III nitride device is typically mounted in a semiconductor package. The choice of package can be diverse and may have top side cooling, bottom side cooling, or double side cooling in discrete packages. A further option is embedding of the die into the circuit board. This option has the advantage of a very low parasitic inductances which enable high switching speed with a low voltage overshoot and high efficiency but also provide an ease of electrical connections to all three terminals of the chip by electroplating, i.e. depositing a copper layer to ensure the best possible electrical connection to carry a large current. The isolated rear side of the die can be easily connected to the copper plane of the circuit board, for example FR4, which can be now brought in direct contact with the heatsink for effective cooling. As a result, a large current can be channeled to the chip and effectively cooled by electrically isolated and thermally coupled backside of the die. This way a very high power density can be achieved.

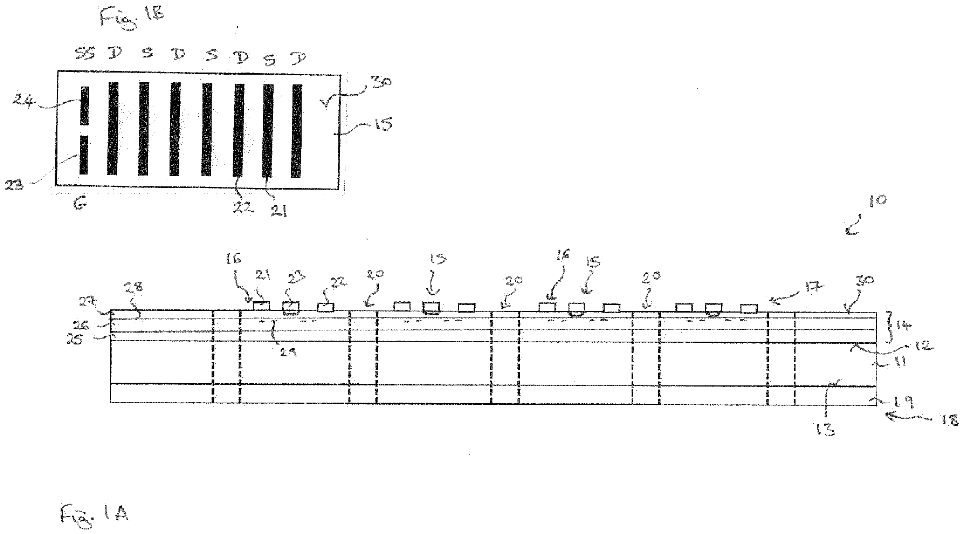

Figure 1A illustrates a cross-sectional view of a semiconductor wafer 10 and figure 1B illustrates a top view of a semiconductor die 15.

The semiconductor wafer 10 comprises a base substrate 11 which comprises a first major surface 12 and a second major surface 13 which opposes the first major surface 12. The wafer 10 further comprises a Group III nitride layer 14 arranged on the first major surface 12 of the base substrate 12. The layer Group III nitride layer 14 comprises a plurality of device positions 15. The device positions 15 of the wafer 10 are commonly arranged in a regular array of rows and columns with each device position 15 being spaced apart from neighbouring device position by a non-device region 20 which may also be referred to as a saw street or kerf region.

One or more Group III nitride devices 16 are arranged in one or more of the device positions 15. For example, each of the device positions 15 may comprise a Group III nitride-based transistor device, such as a Group III nitride-based HEMT. The wafer 10 further comprises a first metallization structure 17 which is arranged on the Group III nitride layer 14 and a second metallization structure 18 which is arranged on the second major surface 13 of the base layer 11.

One or both of the first metallization structure 17 and the second metallization structure 18 may include one or more layers.

The first major surface 12 of the base substrate 11 provides a growth surface which is capable of supporting the epitaxial growth of at least one Group III nitride layer and, therefore, the Group III nitride layer 14. The base layer 11 comprises a material other than a Group III nitride. For example, the substrate 11 may be formed of silicon or sapphire. The base substrate 11 may be formed of monocrystalline silicon substrate. In some embodiments, the base substrate 11 is formed of monocrystalline silicon, for example a single crystal silicon wafer or epitaxial silicon layer. In some embodiments, the first major surface 12 of the base substrate 11 has a <111 > Si orientation. In some embodiments the base substrate 11 is doped with a first conductivity type, e.g. p-type. In some embodiments, the base substrate 11 is formed of monocrystalline silicon, for example a single crystal silicon wafer or epitaxial silicon layer, and the first conductivity type is p-type so that the base substrate 11 is formed of p-type monocrystalline silicon.

The second metallization structure 18 comprises an electrically insulating inorganic layer 19 which is arranged directly on second major surface 13 of the base substrate 11. The electrically insulating inorganic layer 19 entirely and uninterruptedly covers the rear side 13 of the base substrate 11. In an embodiment, the second metallization structure 18 is devoid of any electrically conductive layer. In an alternative embodiment, the second metallization structure 18 further comprises one or more electrically conductive layers arranged on the electrically insulating inorganic layer 19.

The electrically insulating inorganic layer 19 may be formed of a ceramic and may be formed of an oxide and/ or nitride. In some embodiments, the electrically insulating inorganic layer 19 is formed of silicon dioxide.

The electrically insulating inorganic layer 19 is used to electrically isolate the base substrate 11 and the Group III nitride device 16 from the package at on chip level and to decouple the electrical path from thermal path of the device. The thermal resistance of the electrically insulating inorganic layer 19 is low as it has a small thickness. The electrically insulating layer 19 provides a thin thermal interface layer at the die level to provide improved thermal cooling of the die.

The electrically insulating inorganic layer 19, e.g. an oxide, can be deposited at the wafer level. After the oxide is on the rear side 13 of the base substrate 11, the wafer is singulated into single dies 15, each having an electrically insulating layer 19 on the rear surface 13 (back side). The devices 15 may be soldered onto a circuit board and a heat sink attached directly on the SiO₂ back side insulating layer. In this embodiment, the second metallization structure 18 is devoid of an electrically conductive layer and the electrically insulating inorganic layer 19 entirely and uninterruptedly covers the rear side 13 of the base substrate 11.

The electrically insulating layer 19 may have a thickness in the range of 25 nm to 6500 nm. The material and/or thickness of the electrically insulating layer 19 may be selected to provide electrical isolation suitable for the Vds rating of the device. For example, for a silicon base substrate 11 and a SiO₂ layer 19, the thickness d of the electrically insulating layer 19 may be selected according to the formula 1 * Vds (in V) < d (in nm) < 100 * Vds (in V). Vds may lie in the range of 25V to 650V.

Figure 1B illustrates a top view of a semiconductor die 15 comprising a lateral Group III nitride transistor device 16, e.g. a HEMT, formed in one of the device positions 15, which after singulation from the wafer 10 provides a semiconductor die 15 comprising the transistor device 16. Referring to figures 1A and 1B, an example of the first metallization structure 17 comprises, for each transistor device 16, a plurality of elongate pads 21, 22 which may extend substantially parallel to one another and which are alternately connected to source (S) or drain (D), and further comprise a gate pad 23. The source 21, drain 22 and gate 23 are arranged on the outer surface 30 of the Group III nitride barrier layer 27. The source 21 and drain 22 may form ohmic contacts to the two-dimensional electron gas 29. The gate electrode structure 23 may include a p doped Group IIII nitride layer, for example p doped gallium nitride, and a gate metal layer which is arranged on the p doped Group IIII nitride layer. In some embodiments, the gate electrode structure 23 may have a recessed structure. These structures for the gate electrode structure 23 provides an enhancement mode device which is normally off. The first metallization structure 17 may also include further pads, such as a source sense pad 24. The first metallization structure 17 may include two or more metallic layers that connect source, drain and gate contacts to the Group III nitride layer 14 to a respective source pad, drain pad and gate pad. The first metallization structure 17 may also include one or more electrically insulating layers that are arranged between the metallic layers and have a multilayer structure.

In other embodiments, the Group III nitride device 16 is a bidirectional switch. In this embodiment, the first metallization structure 17 comprises at least one first power or ohmic contact pad, at least one second power or ohmic contact pad and at least one gate pad. The at least one first ohmic contact pad and the second ohmic contact pad may each provide an in/out pad.

In some embodiments, the Group III nitride device 16 is a diode and the first metallization structure 17 comprises at least one first ohmic contact pad, which is connected to the anode of the diode, and at least one second ohmic contact pad, which is connected to the cathode of the diode.

The Group III nitride layer 14 comprises a multilayer structure with a plurality of Group III nitride sublayers. In some embodiments, one sublayer of the Group III nitride layer 14 comprises a Group III nitride buffer structure 25 which is arranged on the first major surface 12 of the base substrate 11. A Group III nitride channel sublayer 26 is arranged on the Group III nitride buffer structure 25 and a Group III nitride barrier sublayer 27 is arranged on the Group III nitride channel sublayer 26. The Group III nitride channel sublayer 26 and the Group III nitride barrier sublayer 27 have different compositions and bandgaps and form a heterojunction 28 which is capable supporting a two-dimensional charge carrier gas, e.g. a 2DEG (two-dimensional electron gas, as indicated in the figure 1A by the dashed line 29. In an embodiment, the Group III nitride channel sublayer 26 is formed of GaN and the Group III nitride barrier sublayer 27 is formed of AlGaN, i.e. AlₓGa₍₁₋ₓ₎N, where 0 < x < 1.

A typical transition or buffer structure 25 for a silicon base substrate 11 includes a AIN starting layer, which may have a thickness of several 100nm, which is epitaxially grown on the growth surface 12 of the silicon base substrate 11 followed by a AlₓGa₍₁₋ₓ₎N layer sequence, the thickness again being several 100nm's for each layer, whereby the Al content of about 50-75% is decreased down to 10-25% before the GaN layer or AlGaN back barrier, if present, is grown. Alternatively, a superlattice buffer can be used. Again, an AIN starting layer on the silicon substrate is used. Depending on the chosen superlattice, a sequence of AIN and AlₓGa₍₁₋ₓ₎N pairs is grown, where the thickness of the AIN layer and AlₓGa₍₁₋ₓ₎N is in the range of 2-25nm. Depending on the desired breakdown voltage the superlattice may include between 20 and 100 pairs. Alternatively, an AlₓGa₍₁₋ₓ₎N layer sequence as described above can be used in combination with the above mentioned superlattice.

In some non-illustrated embodiments, the Group III nitride-based semiconductor layer 14 may further include a back barrier layer. The channel layer 26 is formed on the back barrier layer and forms a heterojunction with the back barrier layer and the barrier layer 27 is formed on channel layer 26. The back barrier layer has a different bandgap to the channel layer and may comprise AlGaN, for example. The composition of the AlGaN of the back barrier layer may differ from the composition of the AlGaN used for the barrier layer 27.

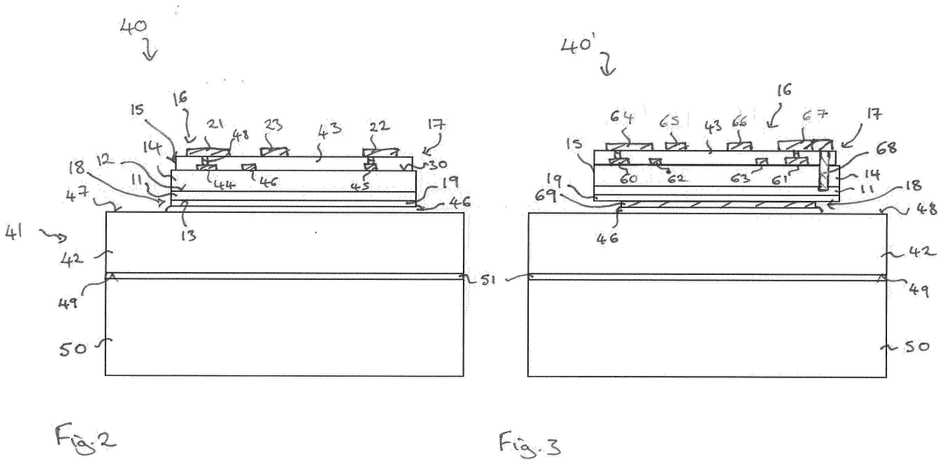

Figure 2 illustrates a cross-sectional view of a semiconductor component 40 according to an embodiment. The semiconductor component 40 comprises a semiconductor die 15, which may have the structure shown in figure 1, and an electrically conductive redistribution structure 41 which comprises an electrically conductive die pad 42. The redistribution structure 41 may further comprise one or more leads or contact pads, which cannot be seen in the cross-sectional view of figure 2, which are spaced apart from the die pad 42. The redistribution structure 41 may form part of a semiconductor package which includes a housing, for example in the form of a plastic molding, which covers the semiconductor die 15. The package may have a standard JEDEC outline for example.

The semiconductor die 15 comprises a Group III nitride layer 14 in which a Group III nitride-based device 16 is formed. The multilayer structure of the Group III nitride layer 14 is not illustrated in figure 2. The Group III nitride device 16 is a transistor device, such as a HEMT. The epitaxial Group III nitride layer 14 is located on the first major surface 12 of the base substrate 11 which provides the growth surface. The electrically insulating inorganic layer 19 is arranged on the second major surface 13 of the base substrate 11.

In this embodiment, the Group III nitride device 16 is a lateral transistor device and comprises a source contact 44, a drain contact 45 and a gate electrode 46 which are arranged on the upper surface 30 of the Group III nitride layer 14. The first metallization structure 17 is formed on the upper surface 30 of the Group III nitride layer 14 and comprises a source pad 21, a gate pad 23 and a drain pad 22 and at least one electrically insulating layer 43. The source contact 44 is electrically connected to the source pad 21 by an electrically conductive redistribution structure 45 which includes a conductive via 48 extending through the electrically insulating layer 43. Similarly, the gate electrode 46 is electrically coupled to the gate contact 23 by the redistribution structure 45 and the drain contact 45 is electrically connected to the drain pad 22 by a respective electrically conductive redistribution structure 45.

The semiconductor die 15 is mounted on the electrically conductive die pad 42 by die attach material 46 which is positioned directly between the electric insulating inorganic layer 19 and the upper surface 47 of the electrically conductive die pad 42. The Group III nitride device 16 is electrically insulated from the electrically conductive die pad 42 at least in part by the electrically insulating inorganic layer 19 arranged on the second major surface 13 of the base substrate 11. In embodiments in which the base substrate 11 is electrically conductive, for example is formed of p-doped silicon, the base substrate 11 is electrically insulated from the electrically conductive die pad 42 at least in part by the electrically insulating inorganic layer 19 arranged on this second major surface 13. The die attach material 46 may be electrically insulating or electrically conductive. The die attach material 46 may be soft solder, a diffusion solder or a polymer based thermosetting adhesive. Whereas the soft solder and diffusion solder are electrically conductive, the polymer based thermosetting adhesive maybe electrically insulative or electrically conductive.

The redistribution structure 41 may be formed by a leadframe metallic comprising a metallic die pad 42 and one or more metallic leads that are arranged spaced part from the die pad. One or more metallic leads may be integral with the die pad 42. In other embodiments, the redistribution structure 41 comprises a circuit board which comprises the die pad 42. In embodiments in which the redistribution structure comprises a circuit board, the die pad 42 may have the form of a conductive pad formed on an electrically insulating layer of the circuit board. The leads may be formed by electrically conductive pads that are also formed on the electrically insulating layer of the circuit board.

The semiconductor die 15 is mounted on the first major surface 47 of the die pad 42. In some embodiments, a heatsink 50 may be located on to the opposing second surface 49 of the die pad 42. The heatsink 50 may be attached to the second major surface 49 of the die pad 42 by various materials 51, including soft solder or a polymer based thermosetting adhesive or a thermal interface material, such as a thermal paste or gap filler, or an interface 51 may be formed between the die pad 42 and the heatsink 50, for example if copper to copper bonding is used.

In some embodiments, the second metallization structure 18 further comprises an electrically conductive layer 69 which is arranged on the electrically insulating inorganic layer 19. The electrically conductive layer 69 may form the outermost surface of the second metallization structure 18. Figure 3 illustrates an example of a second metallization structure 18 with such an outer electrically conducive layer 69 which is electrically insulated from the base substrate 11 and the semiconductor device 16 in the Group III nitride layer 14 by the intervening electrically insulating inorganic layer 19 that is positioned directly on the second major surface 13 of the base substrate. The electrically insulating inorganic layer 19 and the electrically conductive layer 69 entirely cover the rear surface 13 of the base substrate 11. The second metallization structure 18 of the dies shown in the other embodiments described and illustrated herein may also include this electrically conductive layer 69. The electrically conductive layer 69 may comprise two or more sublayers, for example a lower layer, e.g. copper that is in direct contact with the electrically insulating inorganic layer 19 and an outermost solderable layer that is in contact with the lower layer. An adhesion promotion layer may be arranged between the lower layer and the electrically insulating inorganic layer 19.

Figure 3 illustrates a cross-sectional view of a semiconductor component 40' which comprises a semiconductor device die 15 comprising a semiconductor device 16, for example a transistor device 16, a die pad 42 and heatsink 50 similar to the embodiment illustrated in figure 2. The semiconductor component 40' differs from that illustrated in figure 2 in that the semiconductor device 16 is a bidirectional switch which comprises first and second ohmic contacts 60, 61 and two gates 62, 63 which are laterally arranged between the two ohmic contact 60, 61 and on the upper surface 30 of Group III nitride layer 14. The first ohmic contact 60 is electrically connected to a first contact pad 64, the gate electrode 62 to a first gate pad 65, the second gate electrode 63 to a second gate pad 66 and the second ohmic contact 61 to a second ohmic contact pad 67 of the first metallization structure 17 which is arranged on the upper surface of the electrically insulating layer 43 of the first metallization structure 17.

In this embodiment, the base substrate 11 is electrically conductive and is formed of p-doped monocrystalline silicon. The base substrate 11 is electrically connected to at least a portion of the first metallization structure 17, for example the second ohmic contact pad 67, by means of an electrically conductive vertical connection 68 which extends from the base substrate 11 through the Group III nitride layer 14 and the electrically insulating layer 43 of the first metallization structure 17 and is electrically connected to the first ohmic contact pad 67. In this embodiment, the base substrate 11 is electrically coupled to the first ohmic contact pad 67. The electrically conductive vertical connection 68 may be formed by a p-doped sinker which is formed by a region of the Group III nitride layer 14 that is p-doped. Alternatively, the electrically conductive vertical connection 68 may be formed by a conductive via, e.g. a through substrate via. The conductive via may comprise a hole which extends from the upper surface 30 of the Group III nitride layer 14 into the bae substrate 11 which is lined or filled with one or more electrically conductive materials, e.g. metals.

If the device 16 is a transistor device, the base substrate 11 may be electrically coupled to source potential or drain potential. For example, the conductive vertical electrical connection 68 may be electrically coupled to the drain pad 22 or source pad 21 of the transistor device 16. If the device is a bidirectional switch, the conductive vertical connection 68 may be coupled to one of the ohmic contact pads 60, 61 of the bidirectional switch.

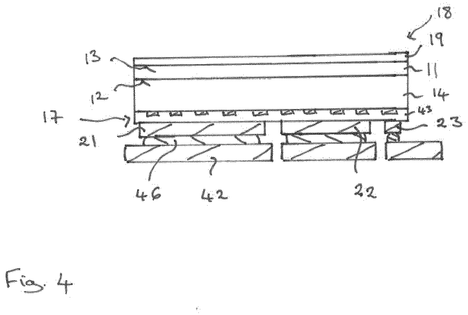

Figure 4 illustrates a cross-sectional view of a semiconductive component 40" which comprises a semiconductor die 15 comprising a Group III nitride device 16 formed in the Group III nitride layer 14 form on the base substrate 11 and a redistribution structure 41 comprising a die pad 42. The semiconductor component 40" differs from that illustrated in figures 2 and 3 in that the semiconductor die 15 has the reverse arrangement of that illustrated in figures 2 and 3 with respect to the die pad, namely a so-called flip chip arrangement. In Figure 4, the first metallization structure 17 faces towards the die pad 42 and the electrically insulating inorganic layer 19 faces outwardly away from the die pad 42. In this embodiment, the first metallization structure 17 is mounted on the die pad 42. A heatsink 50 may be attached to the upwardly facing electrically insulating inorganic layer 19.

In some embodiments, one of the one or more of the pads of the first metallization structure 17, which are electrically connected to the same potential, for example source potential, are mounted on, and electrically connected to, the die pad 42. For example, the source pad 21 of the transistor device 16, which is coupled ground potential, may be mounted on, and electrically connected to the die pad 42. The semiconductor die 15 may be situated such that the gate pad 23 and the drain pad 22 are positioned laterally adjacent the periphery of the die pad 42 and mounted on and electrically connected to a respective pad of the redistribution structure 41.

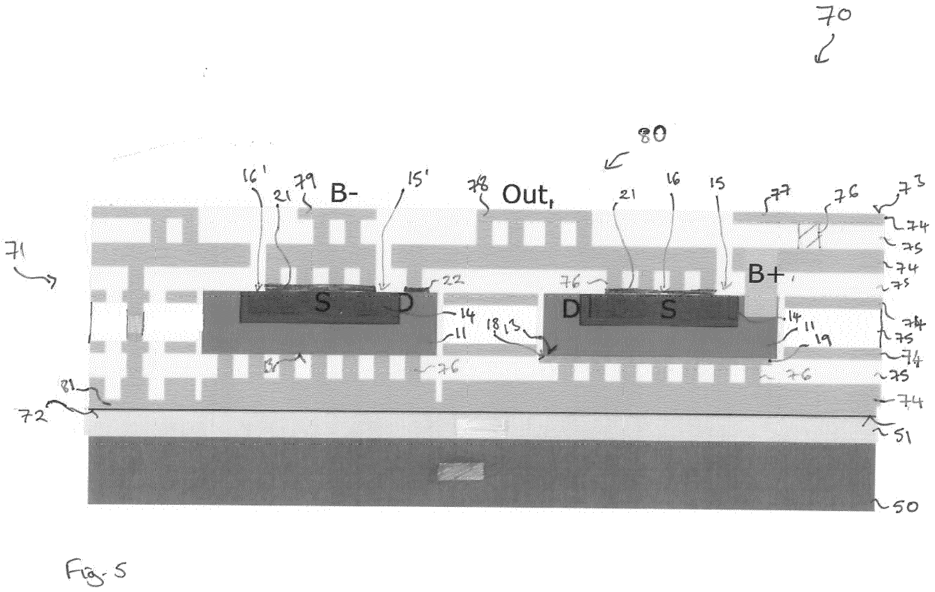

Figure 5 illustrates a cross-sectional view of a semiconductor component 70 which comprises a circuit board 71 in which the semiconductor die 15 according to any one of the embodiments described herein is embedded. The circuit board 71 comprises first outer surface 72, a second outer surface 73 which opposes the first outer surface 72 and a stacked structure of alternate electrically conductive layers 74 and electrically insulating layers 75. The number of inorganic layers 75 and conductive layers 74 of the circuit board 71 may vary from that illustrated in figure 5.

The circuit board 71 comprises an electrically conductive redistribution structure which comprises the plurality of electrically conductive layers 74 and a plurality of conductive vias 76 which extend between the electrically insulating layers 75 arranged between electrically conductive layers 74 of the stack to provide a three-dimensional electrically conductive redistribution structure. The electrically conductive layers 74 may be structured to provide two or more portions that are separate from one another and electrically insulated from one another by the adjoining electrically insulating layers of the stack.

The semiconductor die 15 is embedded in the circuit board 71, in particular in one of the electrically insulating layers 75, for example in a core layer formed of reinforced epoxy, e.g. fibre-reinforced epoxy, and is electrically connected to the electrically conductive redistribution structure. In this embodiment, the electrically insulating inorganic layer 19 which is arranged on the second major surface 13 of the base substrate 11 of the semiconductor die 15 serves to electrically insulate the semiconductive die 15 from the electrically conductive redistribution structure of the circuit board 61. In some embodiments, the electrically insulating inorganic layer 19 may be in direct contact with one of the conductive layers 74 or with one or more conductive vias 76 and electrically insulates the semiconductor die from that conductive layer 74 or via 76.

In some embodiments, such as that illustrated in figure 5, more than one semiconductor die 15, 15' is embedded in the circuit board 71 and the redistribution structure of the circuit board can be used to electrically connected the semiconductor dies with one another and provide a circuit. For example, first and second semiconductor dies 15, 15', each comprising a lateral transistor device such as a Group III nitride transistor device 16, 16', for example a HEMT, may be electrically connected to one another by way of the redistribution structure of the circuit board to provide a half bridge circuit 80.

In some embodiments, the semiconductor die 15 provides the high side switch and the second semiconductor die 15' the low side switch of the half bridge circuit 80. The second semiconductor die 15' is also embedded in the circuit board 71 and may be substantially coplanar with the semiconductor die 15. The first and second semiconductor dies 15, 15' may be embedded laterally adjacent one another in an electrically conductive layer 74 of the circuit board 71. In this embodiment, the drain pad 22 of the first semiconductor die 15 is electrically connected to the high voltage contact pad 77 of the half bridge circuit and the source pad 21 is electrically connected to the output pad 78 of the half bridge circuit. The second semiconductor die 15' also includes a drain pad 22, gate pad 23 and source pad 21 on its upper surface 30. The drain pad 22 of the second semiconductor die 15' is electrically connected to the output pad 78 located on the second outer surface 73 of the circuit board 61 and the source pad 21 is electrically connected to the low voltage pad 79 of the half bridge circuit 80 which is located at the second outer surface 72 of the circuit board 71. The rear surface 13 of the base substrate 11 of the second semiconductor die 15' may be without the electrically insulating inorganic layer so that the second major surface 13 of the base substrate 11 is in direct contact with either a conductive layer 74 or conductive via 76 of the redistribution structure.

In the embodiment illustrated in figure 5, the second major surface 13 of the base substrate 11 of the second semiconductor die 15', which provides the low side switch, is electrically coupled to a common conductive layer 81 which forms the first outer surface 72 of the circuit board 71. The common conductive layer 81 may provide a ground plane. The base substrate 11 of the second semiconductor die 15' may be electrically connected to the common conductive layer 81. The source pad 21 of the second transistor device 16' may be electrically connected by way of the base substrate 11 and a conductive via within the semiconductor die 15' to the conductive layer 81. The source pad 21 of the second transistor device 16' is electrically insulated from the drain pad 22 of the second transistor device 16' which is electrically connected to the output pad 78.The electrically insulating inorganic layer 19, which is arranged on the second major surface 13 of the base substrate 11 of the first semiconductor die 15, which provides the high side switch 15 of the half bridge circuit 80, is mechanically coupled to the common conductive layer 81 by means of conductive vias 76. The base substrate 11 and the transistor device 16 of the first semiconductor die 15 are electrically insulated from the conductive vias 76 and the ground plane 81 by the electrically insulating inorganic layer 19 that is formed on the rear side 13 of its base substrate 11. The common conductive layer 81 may be mounted on a heatsink 50 by means of attachment material 51 which may be either electrically conductive or electrically insulating.

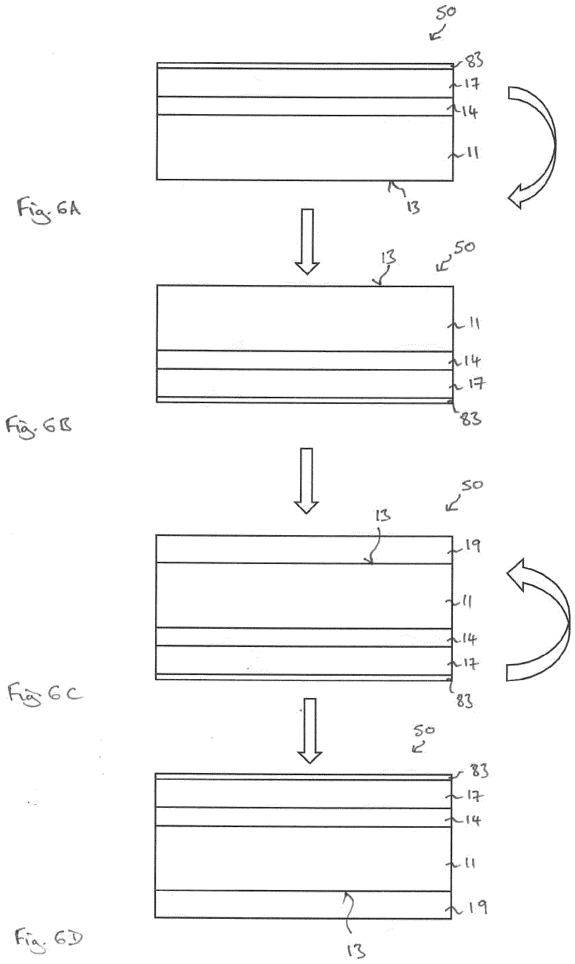

Figure 6, which includes figure 6A to 6D, illustrates a method for fabricating a semiconductor wafer 50 which comprises a plurality of component positions that are not shown in figure 6. A wafer 50 having the structure shown in figure 1A may be used. However, the method may also be used for a semiconductor die.

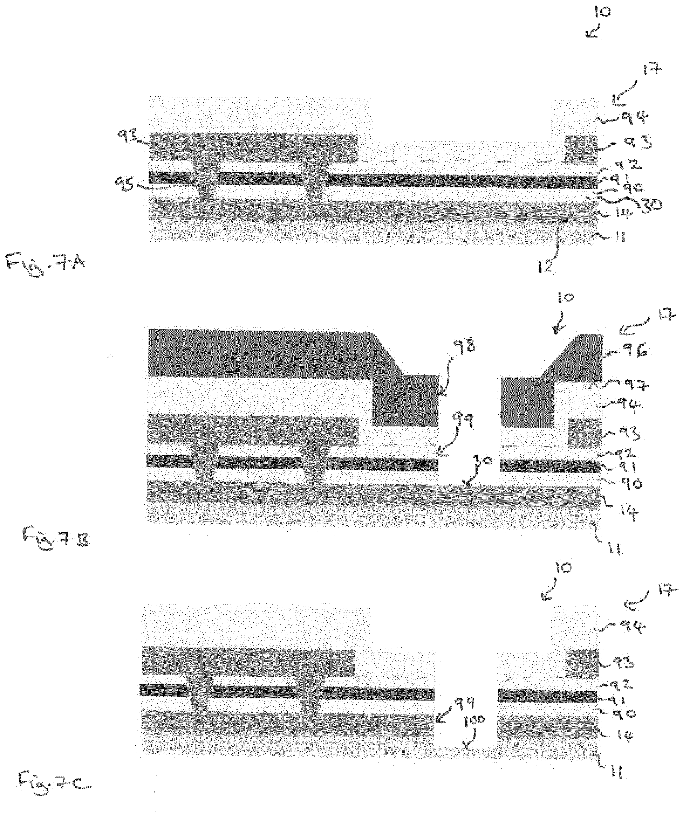

Referring to figure 6A, the wafer 50 comprises a silicon base wafer 11, a Group III nitride layer 14 arranged on the growth surface 13 of the silicon base layer 11, a first metallization structure 17 arranged on the upper surface 30 of the Group III nitride layer 14 which comprises an outermost passivation layer 83. As shown in figure 7B, the wafer 50 is then be inverted such that the second major surface 13 of the wafer 50 faces upwardly and the passivation layer 83 faces downwardly. Referring to figure 6C, the electrically insulating inorganic layer 19 of the second metallization structure 18 is formed on the second major surface 13 of the base substrate 11, for example by MOPVD. In embodiments in which the electrically insulating inorganic layer 19 is SiO₂, the SiO₂ may be grown by PECVD (Plasma Enhanced Chemical Vapour Deposition), LPCVD (Low Pressure Chemical Vapour Deposition), a TEOS (Tetraethylorthosilicate) process or may be thermally grown on Si.

In some embodiments, a conductive layer may be formed on the electrically insulating layer 19 and structured so as to remove regions of the conductive layer and exposed regions of the electrically insulating organic layer 19 that are arranged at the periphery of the device positions. This method may be used to fabricate the second metallization structure 18 illustrated in figure 3. As shown in figure 6D, the wafer 50 is then inverted so that the passivation layer 83 faces upward and the electrically insulating inorganic layer 19 faces downward.

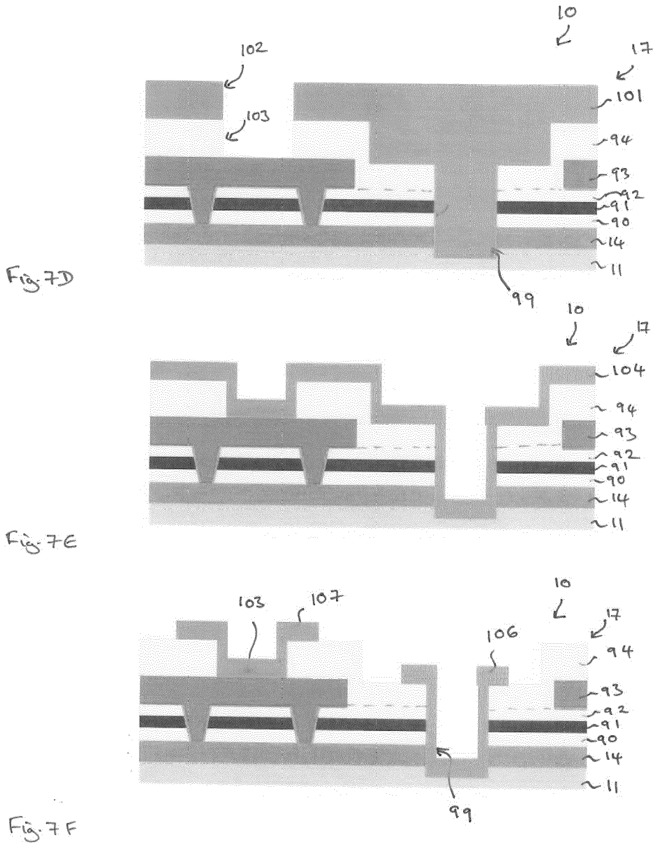

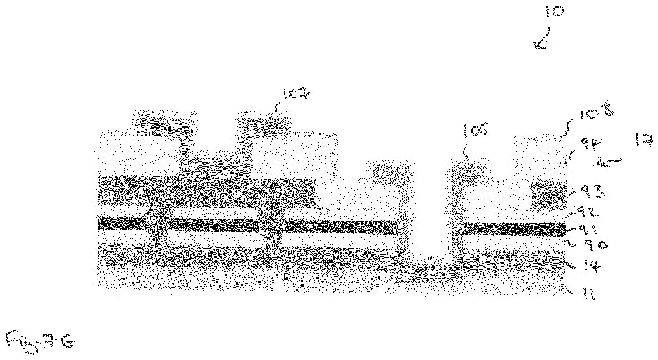

Figure 7, which includes figures 7A to 7G illustrates a method for forming a vertical connection to a base substrate 11 and may be used to fabricate the semiconductor die 15 illustrated in figure 3, for example.

Figure 7A illustrates a cross-sectional view of a portion of a semiconductor substrate 10 which comprises a base substrate 11, a Group III nitride layer 14 which is epitaxially grown on the first major surface 12 of the base substrate 11 and which comprises multiple sublayers of Group III nitrides and a Group III nitride device 16, for example a transistor device such as a HEMT.

A first metallization structure 17 is arranged on the upper surface 30 of the Group III nitride layer 14 and comprises a first passivation layer 90 arranged on the upper surface 30 of the Group III nitride layer 14, a second passivation layer 91 arranged on the first passivation layer 90 and a third passivation layer 92 arranged on the second passivation layer 91. The first and third passivation layers 90, 92 may be formed of an oxide, for example silicon oxide such TEOS. The second passivation layer 91 may be formed of a nitride, for example silicon nitride. The first metallization structure 17 further comprises a first electrically conductive layer 93, e.g. a metallic layer, that is arranged on the third passivation layer 92 and a first interlayer dielectric layer 94 is arranged on the first electrically conductive layer 93. The first interlayer dielectric layer may be formed of TEOS. The first electrically conductive layer 93 may be structured so as to provide two or more portions that are separate from one another. Each portion may be connected to a different potential or contact of the semiconductor device 16, for example either source, drain or gate. The first electrically conductive layer 93 may be formed of aluminium or aluminium alloy such as aluminium copper alloy. The first electrically conductive layer 93 may also comprise two or more sublayers. For example a TiN barrier layer, a tungsten sublayer grown by CVD and an upper aluminium copper sublayer on the tungsten sublayer may be used. One or more contact vias 95 are formed which extends through the first, second and third passivation layers 90, 91, 92 between the first electrically conductive layer 93 and one type of the contacts of the Group III nitride device, for example the source contacts 21.

Referring to figure 7B, a first mask 96, which may be formed of photoresist, is applied to the outer surface 97 of the first interlayer dielectric 94 and structured to form a first mask opening 98. The first mask opening 98 is positioned laterally adjacent the first metallic layer 93. An etching process, for example plasma etching, is carried out to remove the electrically insulating layers exposed at the base of the first mask opening 98 so as to form a first opening 99 which extends through the first interlayer dielectric 94 and the first, second and third passivation layers 90, 91, 92 and which has a base formed by the upper surface 30 of the Group III nitride layer 14.

Referring to figure 7C, the first mask 96 is then removed and a further etch process is carried out which removes the Group III nitride material exposed at the base of the opening 99 and further extends the depth of the opening 99 such that it has a base 100 positioned in the base substrate 11.

Referring to figure 7D, a second mask 101, which may be formed of photoresist, is applied which fills the opening 99 and covers the first interlayer dielectric 94. A second mask opening 102 is formed in the second mask 101 which is positioned above the first conductive layer 93 and an etch process carried out to remove exposed region of the first interlayer dielectric 94 and expose a portion of the first electrically conductive layer 93 and form a second opening 103 in the first interlayer dielectric 94. A plasma etch may be used.

Referring to figure 7E, the second mask 101 is removed and a second electrically conductive layer 104 is deposited which lines the second opening 103 and the first opening 99. The second electrically conductive layer 104 may be deposited and cover the upper surface 105 of the first interlayer dielectric 94 as well as the sidewalls and base of the first and second openings 99, 103. The second electrically conductive layer 104 may be formed of aluminium or aluminium alloy, such as aluminium copper alloy.

Referring to figure 7F, the second conductive layer 104 may be structured so as to form two discrete and separate through contacts 106, 107. The first through contact 106 is positioned in the first opening 99 and provides a contact to the base substrate 11 of the transistor device 16 and the second contact 107 is positioned in the second opening 103 and forms an electrical contact to the source contact 22 of the transistor device 16.

The second electrically conductive layer 105 may be structured by applying a photoresist layer, structuring the photoresist layer to form an opening above each of the first and second openings 99, 103, performing an etching process, for example wet chemical etch, and removing the photoresist. In some embodiments, an annealing process may then be carried out. The annealing process may improve the contact between the material of the second electrically conductive contact 105 and the base substrate 11.

Referring to figure 7G, in some embodiments, the method may continue by depositing a passivation layer 108 conformally over the structure illustrated in figure 7F.

A Group III nitride-based semiconductor die is provided with an inorganic die isolation layer that is deposited directly onto the base substrate of the die. The inorganic die isolation layer has a small thickness, e.g. less than 1 µm. This thickness can be well controlled thereby providing improved thermal cooling of the die. A small semiconductor die, e.g. a die having an area 10mm², may be utilized to achieve the desired low Rds.on and be effectively cooled in order to alleviate the thermal stress of the die. The inorganic isolation layer can be used to electrically isolate the die from the package on chip level and in this way decouple electrical path from thermal path of the die.

### Examples

Example 1. A semiconductor die, comprising:
a base substrate comprising a first major surface and a second major surface opposing the first major surface, the base substrate comprising a material other than a Group III nitride;
a Group III nitride layer arranged on the first major surface of the base substrate and comprising a Group III nitride device;
a first metallization structure arranged on the Group III nitride layer;
a second metallization structure arranged on the second major surface of the base layer and comprising an electrically insulating inorganic layer arranged directly on the second major surface.

Example 2. A semiconductor die according to example 1, wherein
the Group III nitride device is a transistor device and the first metallization structure comprises at least one source pad, at least one drain pad and at least one gate pad, or
the Group III nitride device is a bidirectional switch and the first metallization structure comprises at least one first ohmic contact pad, at least one second ohmic contact pad and at least one gate pad, or
the Group III nitride device is a diode and the first metallization structure comprises at least one first ohmic contact pad and at least one second ohmic contact pad,

Example 3. A semiconductor die according to example 1 or example 2, wherein the Group III nitride layer comprises a Group III nitride buffer structure that is arranged on the first major surface of the base substrate, a Group III nitride channel sublayer arranged on the Group III nitride buffer structure and a Group III nitride barrier sublayer arranged on the Group III nitride channel sublayer and forming a heterojunction therebetween.

Example 4. A semiconductor die according to example 2 or example 3, wherein the Group III nitride transistor device is a HEMT.

Example 5. A semiconductor die according to any one of examples 1 to 4, wherein the second metallization structure further comprises a conductive layer arranged on the electrically insulating inorganic layer, or the second metallization structure is devoid of an electrically conductive layer.

Example 6. A semiconductor die according to example 5, wherein peripheral regions of the electrically insulated inorganic layer remain exposed from the conductive layer.

Example 7. A semiconductor die according to any one of examples 1 to 6, wherein the electrically insulating inorganic layer is formed of an oxide or a nitride.

Example 8. A semiconductor die according to any one of examples 1 to 7, wherein the electrically insulating inorganic layer is formed of silicon dioxide.

Example 9. A semiconductor die according to any one of examples 1 to 8, wherein the base substrate is formed of a monocrystalline silicon substrate.

Example 10. A semiconductor die according to any one of examples 1 to 9, wherein the first major surface of the monocrystalline silicon substrate has a <111> orientation.

Example 11. A semiconductor die according to any one of examples 1 to 10, wherein the base substrate is doped with a first conductivity type.

Example 12. A semiconductor die according to example 11, wherein the first conductivity type is p-type.

Example 13. A semiconductor die according to any one of examples 1 to 12, wherein the base substrate is electrically coupled to at least portion of the first metallization structure by a conductive vertical connection.

Example 14. A semiconductor die according to example 13, herein the conductive vertical connection comprises a doped sinker or a conductive via.

Example 15. A semiconductor die according to example 13 or example 14, wherein the base substrate is coupled to source potential or drain potential.

Example 16. A semiconductor component, comprising:
a semiconductor die according to any one of examples 1 to 15,
a redistribution structure comprising an electrically conductive die pad;
wherein the semiconductor die is mounted on the die pad by die attach material and the Group III nitride device is electrically insulated from the electrically conductive die pad at least in part by the electrically insulating inorganic layer arranged on the second major surface of the base substrate.

Example 17. A semiconductor component according to example 16, wherein the die attach material comprises soft solder, diffusion solder, or a polymer-based thermosetting adhesive.

Example 18. A semiconductor component according to example 17, wherein the polymer-based thermosetting adhesive is electrically insulative or electrically conductive.

Example 19. A semiconductor component according to any one of examples 16 to 18, wherein the redistribution structure comprises a leadframe comprising the die pad and a plurality of leads or the redistribution structure comprises a circuit board comprising the die pad.

Example 20. A semiconductor component according to any one of examples 16 to 18, wherein the semiconductor die is mounted on a first side of the die pad by the die attach material and the semiconductor component further comprises a heat sink that is arranged on a second side of the die pad that opposes the first side.

Example 21. A semiconductor component according to any one of examples 16 to 20, wherein the second metallization structure is attached to the die pad by the die attach material or the first metallization structure is attached to the die pad by the die attach material.

Example 22. A semiconductor component according to any one of examples 16 to 21, wherein the electrically insulating inorganic layer is in direct contact with die pad.

Example 23. A semiconductor component according to any one of examples 16 to 21, wherein the second metallization structure comprises a second electrically conductive layer arranged on the electrically insulating inorganic layer and the second electrically conductive layer is in direct contact with the die pad.

Example 24. A semiconductor component, comprising:
a semiconductor die according to any one of examples 1 to 15,
a circuit board comprising a first outer surface, a second outer surface opposing the first outer surface and an electrically conductive redistribution structure,
wherein the semiconductor die is embedded in the circuit board and electrically connected to the electrically conductive redistribution structure,
wherein the second major surface of the base substrate of the semiconductor die is electrically insulated from a conductive layer of the redistribution structure of the circuit board at least in part by the electrically insulating inorganic layer.

Example 25. A semiconductor component according to example 24, wherein the electrically insulating inorganic layer is in direct contact with the conductive layer of the circuit board.

Example 26. A semiconductor component according to example 24 or example 25, wherein the second metallization structure comprises a second electrically conductive layer arranged on the electrically insulating inorganic layer and the second electrically conductive layer is in direct contact with the conductive layer of the circuit board.

Example 27. A semiconductor component according to any one of examples 24 to 26, wherein the Group III nitride device comprises a transistor device and the semiconductor component further comprises a further Group III nitride device that is embedded in the circuit board.

Example 28. A semiconductor component according to example 27, wherein the further Group III nitride device is a transistor device and is electrically coupled with the Group III nitride transistor device to form a half-bridge circuit.

Example 29. A semiconductor component according to example 27 or example 28, wherein the Group III nitride device and the further Group III nitride device are arranged on a common electrically conductive layer and the Group III nitride device is electrically insulated from the common electrically conductive layer by the electrically insulating inorganic layer on the second major surface of the base substrate and the second major surface of the base substrate of the further Group II nitride device is electrically connected to the common electrically conductive layer.

Example 30. A semiconductor component according to example 29, wherein the common electrically conductive layer is arranged at the first outer surface of the circuit board and at least one low voltage contact pad, at least one high voltage contact pad and at least one output pad of the half bridge circuit are arranged on the second outer surface of the circuit board.

Example 31. A semiconductor component according to any one of examples 24 to 30, further comprising a heat sink arranged on the first outer surface of the circuit board.

Example 32. A method, comprising:
forming an electrically insulating inorganic layer on a rear surface of a wafer, the wafer comprising:
a base substrate comprising the rear surface and a growth surface opposing the rear surface, the base substrate comprising a material other than a Group III nitride;
a Group III nitride layer arranged on the growth surface of the base substrate and comprising a plurality of device positions, wherein one or more Group III nitride devices are arranged in one or more of the device positions, and
a first metallization structure arranged on the Group III nitride layer.

Example 33. A method according to example 32, further comprising forming a conductive layer on the electrically insulating inorganic layer.

Example 34. A method according to example 33, further comprising structuring the conductive layer and exposing regions of the electrically insulating inorganic layer that are arranged at the periphery of the device positions from the conductive layer.

Example 35. A method comprising:
forming a first opening in a first metallization structure formed on a Group III nitride layer arranged on a first major surface of a base substrate, wherein the base substrate comprises a material other than a Group III nitride and comprises a second metallization structure arranged on a second major surface of the base layer that opposes the first major surface, the second metallization structure comprising an electrically insulating inorganic layer arranged directly on the second major surface, wherein the Group III nitride layer comprises a Group III nitride device and the first metallization structure comprises one or more electrically insulating layers and one or more electrically conductive layers that are coupled to the Group III nitride device;
increasing the depth of the first opening through the Group III nitride layer and into the base substrate and forming an extended first opening, the extended first opening having a base located in the base substrate;
forming a mask that covers the extended first opening and that exposes a conductive layer of the first metallization structure in a second opening;
removing the mask and forming a conductive layer that lines the second opening, the extended first opening and the outer surface of the first metallization structure;
structuring the conductive layer to form a first portion that is electrically coupled to the base substrate and a second portion that is electrically coupled to the conductive layer of the first metallization structure.

Example 36. A method according to example 35, further comprising thermally annealing the conductive layer.

Example 37. A method according to example 35 or example 36, further comprising forming a passivation layer over the first and second portions of the conductive layer and the first metallization structure.

Example 38. A method according to any one of examples 35 to 37, wherein the forming the first opening comprises:
forming a mask on the first metallization structure,
forming a third opening in the mask and removing the first metallization structure exposed in the third opening of the mask to form the first opening, wherein the base of the first opening is formed by the Group III nitride layer.

Example 39. A method according to any one of examples 35 to 38, wherein the first opening is formed by plasma etching.

Example 40. A method according to any one of examples 35 to 39, wherein the increasing the depth of the opening comprises:
removing the mask,
etching the Group III nitride layer and the base substrate

Example 41. A method according to example 40, wherein the etching is wet etching.

Example 42. A wafer, comprising:
a base substrate comprising a first major surface and a second major surface opposing the first major surface, the base substrate comprising a material other than a Group III nitride;
a Group III nitride layer arranged on the first major surface of the base substrate and comprising a plurality of device positions, wherein one or more Group III nitride devices are arranged in one or more of the device positions;
a first metallization structure arranged on the Group III nitride layer;
a second metallization structure arranged on the second major surface of the base layer and comprising an electrically insulating inorganic layer arranged directly on the second major surface.

Example 43. A wafer according to example 42, wherein
the Group III nitride device is a transistor device and the first metallization structure comprises at least one source pad, at least one drain pad and at least one gate pad, or
the Group III nitride device is a bidirectional switch and the first metallization structure comprises at least one first ohmic contact pad, at least one second ohmic contact pad and at least one gate pad, or
the Group III nitride device is a diode and the first metallization structure comprises at least one first ohmic contact pad and at least one second ohmic contact pad.

Example 44. A wafer according to example 42 or example 43, wherein the Group III nitride layer comprises a Group III nitride buffer structure that is arranged on the first major surface of the base substrate, a Group III nitride channel sublayer arranged on the Group III nitride buffer structure and a Group III nitride barrier sublayer arranged on the Group III nitride channel sublayer and forming a heterojunction therebetween.

Example 45. A wafer according to example 44, wherein the Group III nitride transistor device is a HEMT.

Example 46. A wafer according to any one or examples 42 to 45, wherein the second metallization structure further comprises an electrically conductive layer arranged on the electrically insulating inorganic layer.

Example 47. A wafer according to any one or examples 42 to 46, wherein peripheral regions of the electrically insulated inorganic layer remain exposed from the electrically conductive layer.

Example 48. A wafer according to any one or examples 42 to 47, wherein the electrically insulating inorganic layer is formed of an oxide or a nitride.

Example 49. A wafer according to example 48, wherein the electrically insulating inorganic layer is formed of silicon dioxide.

Example 50. A wafer according to any one or examples 42 to 49, wherein the base substrate is formed of a monocrystalline silicon substrate.

Example 51. A wafer according to example 50, wherein the first major surface of the monocrystalline silicon substrate has a <111 > orientation.

Example 52. A wafer according to any one or examples 42 to 51, wherein the base substrate is doped with a first conductivity type.

Example 53. A wafer according to example 52, wherein the first conductivity type is p-type.

Example 54. A wafer according to any one or examples 42 to 53, wherein the base substrate is electrically coupled to at least a portion of the first metallization structure by a conductive vertical connection.

Example 55. A wafer according to example 54, wherein the conductive vertical connection comprises a doped sinker or a conductive via.

Example 56. A wafer according to any one or examples 42 to 55, wherein the base substrate is coupled to source potential or drain potential.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor die, comprising:
a base substrate comprising a first major surface and a second major surface opposing the first major surface, the base substrate comprising a material other than a Group III nitride;
a Group III nitride layer arranged on the first major surface of the base substrate and comprising a Group III nitride device;
a first metallization structure arranged on the Group III nitride layer;
a second metallization structure arranged on the second major surface of the base layer and comprising an electrically insulating inorganic layer arranged directly on the second major surface.

2. A semiconductor die according to claim 1, wherein
the Group III nitride device is a transistor device and the first metallization structure comprises at least one source pad, at least one drain pad and at least one gate pad, or
the Group III nitride device is a bidirectional switch and the first metallization structure comprises at least one first ohmic contact pad, at least one second ohmic contact pad and at least one gate pad, or
the Group III nitride device is a diode and the first metallization structure comprises at least one first ohmic contact pad and at least one second ohmic contact pad,

3. A semiconductor die according to claim 1 or claim 2, wherein the second metallization structure further comprises an electrically conductive layer arranged on the electrically insulating inorganic layer, or the second metallization structure is devoid of an electrically conductive layer.

4. A semiconductor die according to claim 3, wherein peripheral regions of the electrically insulated inorganic layer remain exposed from the conductive layer.

5. A semiconductor die according to any one of claims 1 to 4, wherein the base substrate is doped with a first conductivity type, wherein the base substrate is electrically coupled to at least portion of the first metallization structure by a conductive vertical connection.

6. A semiconductor component, comprising:
a semiconductor die according to any one of claims 1 to 5,
a redistribution structure comprising an electrically conductive die pad;
wherein the semiconductor die is mounted on the die pad by die attach material and the Group III nitride device is electrically insulated from the electrically conductive die pad at least in part by the electrically insulating inorganic layer arranged on the second major surface of the base substrate.

7. A semiconductor component according to claim 6, wherein the die attach material comprises soft solder, diffusion solder, or a polymer-based thermosetting adhesive.

8. A semiconductor component, comprising:
a semiconductor die according to any one of claims 1 to 5,
a circuit board comprising a first outer surface, a second outer surface opposing the first outer surface and an electrically conductive redistribution structure,
wherein the semiconductor die is embedded in the circuit board and electrically connected to the electrically conductive redistribution structure,
wherein the second major surface of the base substrate of the semiconductor die is electrically insulated from a conductive layer of the redistribution structure of the circuit board at least in part by the electrically insulating inorganic layer.

9. A semiconductor component according to claim 8, wherein the Group III nitride device comprises a transistor device and the semiconductor component further comprises a further Group III nitride device that is embedded in the circuit board.

10. A semiconductor component according to claim 9, wherein the further Group III nitride device is a transistor device and is electrically coupled with the Group III nitride transistor device to form a half-bridge circuit.

11. A semiconductor component according to claim 9 or claim 10, wherein the Group III nitride device and the further Group III nitride device are arranged on a common electrically conductive layer and the Group III nitride device is electrically insulated from the common electrically conductive layer by the electrically insulating inorganic layer on the second major surface of the base substrate and the second major surface of the base substrate of the further Group II nitride device is electrically connected to the common electrically conductive layer.

12. A semiconductor component according to claim 11, wherein the common electrically conductive layer is arranged at the first outer surface of the circuit board and at least one low voltage contact pad, at least one high voltage contact pad and at least one output pad of the half bridge circuit are arranged on the second outer surface of the circuit board.

13. A method comprising:
forming a first opening in a first metallization structure formed on a Group III nitride layer arranged on a first major surface of a base substrate, wherein the base substrate comprises a material other than a Group III nitride and comprises a second metallization structure arranged on a second major surface of the base layer that opposes the first major surface, the second metallization structure comprising an electrically insulating inorganic layer arranged directly on the second major surface, wherein the Group III nitride layer comprises a Group III nitride device and the first metallization structure comprises one or more electrically insulating layers and one or more electrically conductive layers that are coupled to the Group III nitride device;
increasing the depth of the first opening through the Group III nitride layer and into the base substrate and forming an extended first opening, the extended first opening having a base located in the base substrate;
forming a mask that covers the extended first opening and that exposes a conductive layer of the first metallization structure in a second opening;
removing the mask and forming a conductive layer that lines the second opening, the extended first opening and the outer surface of the first metallization structure;
structuring the conductive layer to form a first portion that is electrically coupled to the base substrate and a second portion that is electrically coupled to the conductive layer of the first metallization structure.

14. A method according to claim 13, wherein the forming the first opening comprises:
forming a mask on the first metallization structure,
forming a third opening in the mask and removing the first metallization structure exposed in the third opening of the mask to form the first opening, wherein the base of the first opening is formed by the Group III nitride layer.

15. A method according to claim 14, wherein the increasing the depth of the opening comprises:
removing the mask,
etching the Group III nitride layer and the base substrate.
